(19) Europäisches Patentamt
European Patent Office
Office européen des brevets

(11) Publication number: **0 463 184 A1**

(12) # EUROPEAN PATENT APPLICATION published in accordance with Art. 158(3) EPC

(21) Application number: **91902767.2**

(22) Date of filing: **17.01.91**

(86) International application number:
**PCT/JP91/00044**

(87) International publication number:
**WO 91/10699 (25.07.91 91/17)**

(30) Priority: **18.01.90 JP 7178/90**
**21.02.90 JP 38383/90**

(43) Date of publication of application:
**02.01.92 Bulletin 92/01**

(84) Designated Contracting States:
**DE FR GB**

(51) Int. Cl.5: **C08G 73/10**, H01L 23/29

(71) Applicant: **NIPPON STEEL CHEMICAL CO., LTD.**
**13-16 Ginza 5-chome Chuo-ku**
**Tokyo(JP)**

(72) Inventor: **YAMADA, Yasuharu**
**1-5, Ibori 2-chome Kokurakita-ku**
**Kitakyushu-shi Fukuoka-ken 803(JP)**
Inventor: **FURUKAWA, Nobuyuki**
**18-17, Shimoigusa 2-chome Suginami-ku**
**Tokyo 167(JP)**
Inventor: **WADA, Yukihiro**
**4-1, Takamidai 1-chome Yahatanishi-ku**
**Kitakyushu-shi Fukuoka-ken 807(JP)**
Inventor: **KITAMURA, Kenichi**
**10-3, Nakai 4-chome Kokurakita-ku**
**Kitakyushu-shi Fukuoka-ken 803(JP)**

(74) Representative: **Strehl, Peter, Dipl.-Ing. et al**
**Patentanwälte Strehl Schübel-Hopf Groening**
**Maximilianstrasse 54 Postfach 22 14 55**
**W-8000 München 22(DE)**

(54) **RESIN FOR PROTECTING SEMICONDUCTORS.**

(57) A resin for use in protecting semiconductors which comprises a polyimide containing repeating units represented by general formulae (1), (2) and (3) each in a given proportion, wherein Ar represents at least one member selected between (4) and general formula (5) wherein Z represents a single bond, -CO- or $-SO_2-$; X represents -O- or $-C(CH_3)_2-$; Y represents a single bond, or at least one member selected from among -O-, $-SO_2-$, $-C(CH_3)_2-$ and $-C(CF_3)_2-$; $R_1$ and $R_2$ represent each an alkyl; m is an integer of 0 to 4; $R_3$ and $R_4$ represent each a divalent organic group; $R_5$ to $R_8$ represent each a hydrocarbon group having 1 to 6 carbon atoms; and n is an integer of 1 to 5.

EP 0 463 184 A1

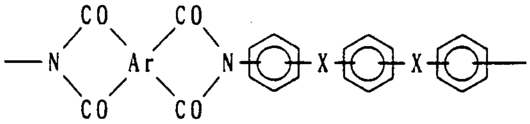

( 1 )

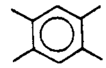

(4)

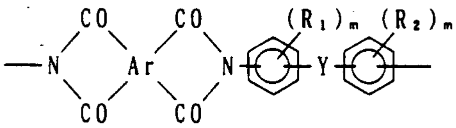

( 2 )

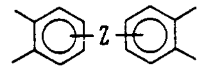

(5)

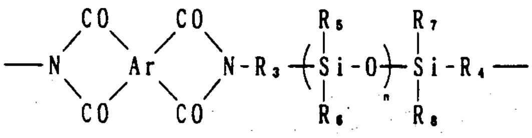

( 3 )

Field of Technology

This invention relates to resins useful for protection of semiconductors and, more particularly, to resins for protection of semiconductors with excellent moisture resistance, electrical properties, and adhesion.

Technical Background

With the recent trend in semiconductors to finer conductor pattern delineation and larger chip size, encapsulating resins liable to aftercure shrinkage and their fillers are developing such defects as sliding of the electrodes on the chip surface and cracking of passivation layers more readily than before and causing a lowering of moisture resistance. In order to reduce the yield loss due to these causes, attempts have been made to lower the stress of encapsulating materials. Apart from them, the use of polyimides as buffer coats has been proposed to relax the stress to be generated between semiconductors of large scale integration and encapsulating materials.

Moreover, the use of polyimides as insulating layers in multi-level interconnections has been studied and in part reduced to practice.

A number of processes have been proposed to accomplish these objectives; for example, a process for using polyamic acids with improved adhesion to semiconductor devices as surface protective films [Japan Kokai Tokkyo Koho Nos. 59-56,453 (1984) and 61-84,025 (1986)] and another process for using heat-resistant polyamic acids as surface protective films [Japan Kokai Tokkyo Koho Nos. 58-218,127 (1983) and 54-74,677 (1979)]. The polyimides prepared by these processes, however, are not sufficient in respect to moisture resistance and stress relaxation. Furthermore, the polyimides in question are not satisfactory as protective films for semiconductors on account of their relatively high dielectric constant.

A still another process has been proposed for the use of diaminopolysiloxanes as comonomer in the preparation of polyimides with low moisture absorption and low modulus as disclosed in Japan Kokai Tokkyo Koho Nos. 62-223,228 (1987) and 63-35,626 (1988). The resins to be obtained by the aforesaid process have a defect of making the formation of through-holes difficult by a wet etching process using positive photoresists.

A process recently proposed is related to the use of polyimides with a low thermal expansion coefficient in order to minimize the stress to be generated between an insulation layer of said polyimides and a silicon wafer. The polyimides of this type, however, have disadvantages of having a high tensile modulus and low mechanical properties and moisture resistance.

Disclosure of the Invention

It is an object of this invention to provide resins for protection of semiconductors which are highly resistant to moisture, adhere strongly to the substrates, show good electrical and mechanical properties, and enable the formation of through-holes by a wet etching process using photoresists.

This invention accordingly relates to resins for protection of semiconductors comprising polyimides having (a) 20 to 80 mol% of the repeating unit represented by the following general formula (1), (b) 10 to 89 mol% of the repeating unit represented by the following general formula (2), and (c) 1-70 mol% of the repeating unit represented by the following general formula (3).

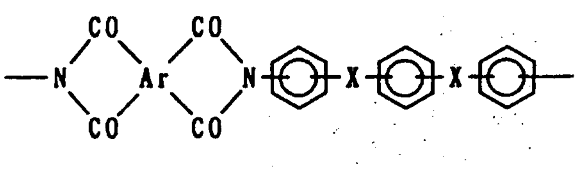

( 1 )

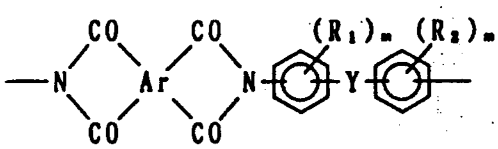

( 2 )

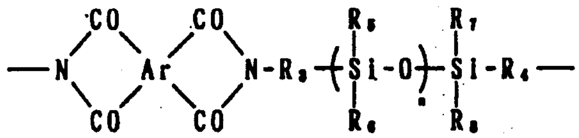

(3)

In the aforesaid general formulas (1), (2), and (3), Ar is at least one radical selected from

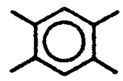

and radicals of the general formula

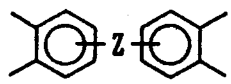

in which Z is a direct bond, -CO-, or $-SO_2-$, X is -O- or $-C(CH_3)_2-$, Y is a direct bond or at least one radical selected from -O-, $-SO_2-$, $-C(CH_3)_2-$, and $-C(CF_3)_2-$, $R_1$ and $R_2$ are alkyl groups, m is an integer from 0 to 4, $R_3$ and $R_4$ are divalent organic radicals, $R_5$ to $R_8$ are hydrocarbon radicals having 1 to 6 carbon atoms, and n is an integer from 1 to 5.

The resins for protection of semiconductors of this invention can be prepared by the reaction of a roughly equimolar mixture of diamines and aromatic tetracarboxylic acid dianhydrides.

The aromatic tetracarboxylic acid dianhydrides useful for the preparation of the resins of this invention are

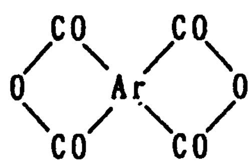

in which Ar is as defined earlier and their examples are pyromellitic dianhydride, 3,3',4,4'-biphenyltetracarboxylic acid dianhydride, 2,3,3',4'-biphenyltetracarboxylic acid dianhydride, 3,3',4,4'-benzophenonetetracarboxylic acid dianhydride, 3,3',4,4'-diphenylsulfonetetracarboxylic acid dianhydride, 3,3',4,4'-diphenylethertetracarboxylic acid dianhydride, and their mixtures. It is desirable to use pyromellitic dianhydride in an amount of 10 mol% or more of the total tetracarboxylic acid dianhydrides. For improved etching by the developers for positive photoresists, it is desirable to use 20 mol% or more, preferably 20 to 80 mol%, of pyromellitic dianhydride.

The diamines useful for the preparation of the resins of this invention are compounds represented by the following general formulas (4), (5), and (6) in which X, Y, $R_1$ to $R_8$, m, and n are as defined earlier.

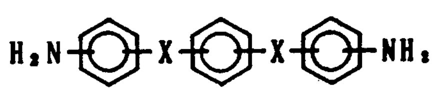

(4)

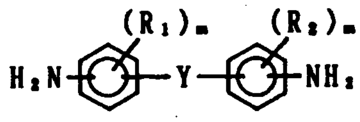

( 5 )

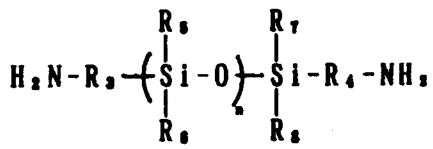

( 6 )

The diamines of the aforesaid general formula (4) include 1,4-bis(4-aminophenoxy)benzene, 1,3-bis(4-aminophenoxy)benzene, 4,4'-(p-phenylenediisopropylidene)bisaniline, 4,4'-(m-phenyle nediisopropylidene)-bisaniline, and their mixtures. The amount of the compounds of the general formula (4) is 20 to 80 mol%, preferably 25 to 70 mol%, of the total diamines. They provide the polyimide unit of the general formula (1), effective for improving the moisture resistance and lowering the dielectric constant. A smaller amount of the compounds of the general formula (4) therefore raises the dielectric constant while a larger amount degrades the wet etching quality.

The diamines of the aforesaid general formula (5) include 3,4'-diaminobiphenyl, 4,4'-diaminobiphenyl, 4,4'-diamino-3,3'-dimethoxybiphenyl, 4,4'-diaminodiphenyl ether, 3,4'-diaminodiphenyl ether, 4,4'-diaminodiphenenyl sulfone, 2,2-bis(4-aminophenyl) hexafluoropropane, 2,2-bis(3-amino-4-methylphenyl)-hexafluoropropane, and their mixtures. They provide the polyimide unit of the general formula (2), effective for good patterning by a wet etching process using positive photoresists. The amount of these aromatic diamines is 10 to 89 mol%, preferably 10 to 79 mol%, more preferably 10 to 50 mol%, and most preferably 20 to 50 mol%, of the total diamines. Any amount outside of this range is undesirable as it raises the modulus.

The diamines of the aforesaid general formula (6) include

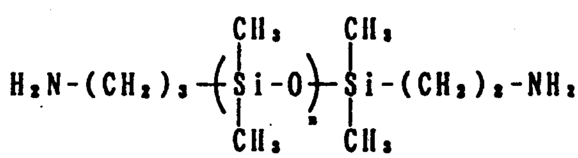

、

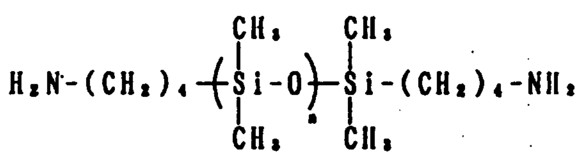

、

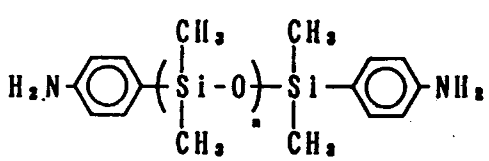

、

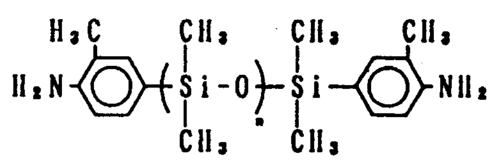

、

and

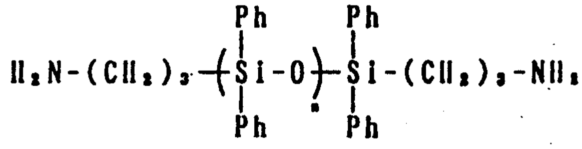

in which n is as defined earlier and Ph is phenyl. They provide the polyimide unit of the general formula (3), effective for improved adhesion.

The average value of n (n) in these diaminosiloxanes is normally 1 to 5. Those with an n in excess of 5 become less miscible with the aromatic components and less soluble in solvents, suffer some deterioration in the etching quality in wet etching, and show lower reactivity with tetracarboxylic acid dianhydrides. The amount of the diaminosiloxanes in question is 1 to 70 mol%, preferably 1 to 15 mol%, of the total diamines. An amount below this range lowers the adhesion to semiconductors while an amount above the range adversely affects the etching quality.

The resins for protection of semiconductors of this invention are prepared by the reaction of the aforesaid diamines and aromatic tetracarboxylic acid dianhydrides effected in the usual manner. The reaction is normally carried out in a solvent until polyamic acids form or complete imidation occurs. The resins of this invention contain the repeating units derived from the aforesaid raw materials and said repeating units must account for 50 mol% or more, preferably 80 mol% or more, more preferably 90 mol% or more, of the total units.

The resins of this invention are advantageously used as solutions of the precursors (polyamic acids) obtained prior to complete imidation in aprotic polar solvents such as N-methyl-2-pyrrolidone, N,N-dimethylacetamide, and dimethylformamide and/or ether linkage-containing solvents such as tetrahydrofuran, diethylene glycol dimethyl ether, diethylene glycol diethyl ether, ethylene glycol diethyl ether, ethylene glycol monoethyl ether acetate, ethylene glycol monomethyl ether acetate, and ethylene glycol monobutyl ether acetate.

The solutions here are spin-coatable even at high resin contents and they are applied and heated at such low temperature for such length of time as to allow stripping of the organic solvent to form pinhole-free films of the polyimide precursors with excellent adhesion, moisture resistance, and mechanical and electrical properties. This helps to cut down the occurrence of semiconductor failures at high temperature and humidity. Moreover, the protective films formed from compositions containing the resins in question are practically free from uranium and thorium and, when encapsulated with epoxy resins and the like, are effective for shielding semiconductors from $\alpha$-particles, contributing to raise the reliability of memory devices.

The protective resins of this invention or compositions mainly consisting of said resins produce particularly desirable results when encapsulated with resins and work more effectively when applied to semiconductor devices of large scale integration, for example, 1 kilobit or more in the case of bipolar type or 16 kilobits or more in the case of MOS type.

The films of the resins are formed on semiconductor devices by such means as spin coating, screen printing, and dispensing.

The polyimide precursors of this invention or a composition containing said polyimide precursors and additives is applied to the surface of a semiconductor and imidized by heating at 250 °C or so to form a protective film of the polyimides or of the composition containing the polyimides.

The use of the resins for protection of semiconductors of this invention enables the formation of good through-holes by a patterning process using positive photoresists. For example, the precursors of the polyimides of this invention are dissolved in the aforesaid solvent, the solution is applied to a substrate such as a silicon wafer and stripped of the solvent at a temperature which does not cause imidation, the resulting film of the polyimide precursors is coated with a positive photoresist in the usual manner, irradiated with actinic rays such as ultraviolet light, and developed with an aqueous alkaline solution. As the film of the aforesaid polyimide precursors is soluble in the aqueous alkaline solution, the exposed positive photoresist is removed by the developer and such part of the precursor film as becoming unprotected thereafter is selectively etched off. It is therefore possible to carry out the development and the patterning of the polyimide precursor film in one step. Upon completion of the development and etching, the photoresist is removed by a parting agent such as acetone and the polyimide precursor film is imidized at 250 to 300 °C to yield a patterned protective film for semiconductors.

The resins for protection of semiconductors of this invention may also be used for a patterning process using negative photoresists. In this case, the aforesaid polyimide precursor solution is applied to a substrate

such as a silicon wafer, dried, and imidized under heat and the resulting protective film is coated with a negative photoresist, exposed, and developed in the usual manner. With the negative photoresist pattern thus formed as a mask, the protective resin film is etched by a solvent such as hydrazine hydrate and then the negative photoresist is removed.

The resins for protection of semiconductors of this invention can be used as passivation film or interlayer insulation film in a thickness of 1 to 100 µm, preferably 1 to 10 µm for passivation films and 1 to 100 µm for interlayer insulation films.

## Detailed Description of the Preferred Embodiments

This invention will be explained in detail with reference to the accompanying examples and comparative examples.

The aromatic tetracarboxylic acid dianhydrides and diamines to be used in the examples and comparative examples are abbreviated as follows.

[Aromatic tetracarboxylic acid dianhydrides]

PMDA: Pyromellitic dianhydride
BTDA: 3,3',4,4'-Benzophenonetetracarboxylic acid dianhydride
BPDA: 3,3',4,4'-Biphenyltetracarboxylic acid dianhydride
DSDA: 3,3',4,4'-Diphenylsulfonetetracarboxylic acid dianhydride

[Aromatic diamines ]

DAE: 4,4'-Diaminodiphenyl ether
BIS-AP: 4,4'-(p-Phenylenediisopropylidene)bisaniline
SIS-AM: 4,4'-(m-Phenylenediisopropylidene)bisaniline
TPE-Q: 1,4-Bis(4-aminophenoxy)benzene
TPE-R: 1,3-Bis(4-aminophenoxy)benzene
BAA-34: 2-(3-Aminophenyl)-2-(4-aminophenyl)propane
3,3'-DDS: 3,3'-Diaminodiphenylsulfone
BIS-A-AF: 2,2-Bis(4-aminophenyl)hexafluoropropane
BIS-AT-AF: 2,2-Bis(3-amino-4-methylphenyl)hexafluoropropane

[Diaminosiloxanes]

PSX-480: ($\bar{n}$ = 4.3)

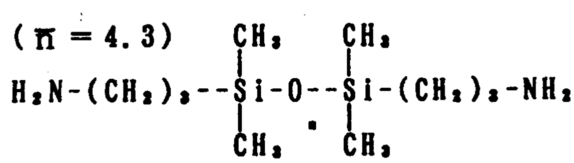

PSX-740: ($\bar{n}$ = 8.4)

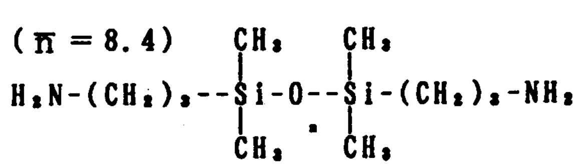

GAPD:

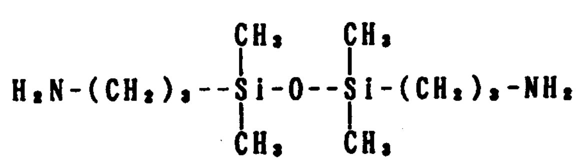

[Reaction solvents ]

NMP: N-Methyl-2-pyrrolidone
Dig: Diethylene glycol dimethyl ether
BCA: Ethylene glycol monobutyl ether acetate

Example 1

A solution of 1.24 g. (0.005 mole) of diaminosiloxane (GAPD) in 50 g. of diethylene glycol dimethyl ether (Dig) was added dropwise in small portions to a dispersion of 4.36 g. (0.02 mole) of pyromellitic dianhydride (PMDA) and 28.64 g. (0.08 mole)of 3,3',4,4'-diphenylsulfonetetracarboxylic acid dianhydride (DSDA) in 240 g. of N-methyl-2-pyrrolidone (NMP), the mixture was allowed to react with stirring for 1 hour, and 14.62 g. (0.05 mole) of powdered 1,3-bis(4-aminophenoxy)benzene (TPE-R) and 9.0 g. (0.045 mole) of powdered 4,4-diaminodiphenyl ether (DAE) were added in small portions in succession.

After completion of the entire addition, 52 g. of diethylene glycol dimethyl ether (Dig) was added to control the solvent composition at NMP/Dig = 7/3 and the solid content at 15% by weight. The mixture was allowed to react further for 5 hours to yield a transparent solution of the polyimide precursors.

The solution viscosity after completion of the reaction was 4,500 centipoises. It was applied by spin coating to a silicon wafer and imidized by heating at 140 °C for 30 minutes, at 250 °C for 30 minutes, and at 300 °C for 60 minutes to form a polyimide film. Table 1 shows the results of the cross-cut tape test (JIS D 0202) together with the contents of radioactive impurities and Table 2 shows the properties of films.

A silicon wafer was spin-coated with the precursor solution, dried at 140 °C for 30 minutes, spin-coated with a positive photoresist (AZ-1350J, product of Shipley Far East Ltd.), dried, selectively exposed through a photomask having a test pattern for the formation of through-holes ranging from 1 µm square to 10 µm square, treated with a developer (MF-312, product of Shipley Far East Ltd.) for simultaneous development of the photoresist and etching of the unprotected portion of the polyimide precursor film (5 µm in thickness), and stripped of the photoresist with acetone. A good 4 µm through-hole pattern was observed on the polyimide precursor film.

Examples 2 - 5

Polyimide precursor solutions were prepared as in Example 1 using the formulations shown in Table 1 and converted to polyimide films. The films were tested for the radioactive impurities and the properties as in Example 1 and the results are shown in Tables 1 and 2.

The patterning test with the photoresist produced a good 4 µm through-hole pattern in each example.

Comparative Examples 1 - 2

Polyimide precursor solutions were prepared as in Example 1 using the formulations shown in Table 1 and converted to polyimide films. All the films showed high moisture absorption. The patterning test with the photoresist did not produce a through-hole pattern of 10 µm or less.

Example 6

A solution of 1.24 g. (0.005 mole) of diaminosiloxane (GAPD) in 50 g. of diethylene glycol dimethyl ether (Dig) was added dropwise in small portions to a dispersion of 4.36 g. (0.02 mole) of pyromellitic anhydride (PMDA) and 28.64 g. ((0.08 mole) of 3,3',4,4'-diphenylsulfonetetracarboxylic acid dianhydride (DSDA) in 240 g. of N-methyl-2-pyrrolidone (NMP), the mixture was allowed to react with stirring for 1 hour, and 17.2 g. (0.05 mole) of powdered 4,4'-(p-phenylenediisopropylidene)bisaniline (BIS-AP) and 9.0 g. (0.045 mole) of 4,4-diaminodiphenyl ether (DAE) were added in small portions in succession.

After completion of the entire addition, 52 g. of diethylene glycol dimethyl ether (Dig) was added to control the solvent composition at NMP/dig = 7/3 and the solid content at 15 % by weight. The reaction mixture was allowed to react further for 5 hours to yield a transparent solution of the polyimide precursors.

The solution viscosity after completion of the reaction was 4,500 centipoises. It was applied by spin coating to a silicon wafer and imidized by heating at 140 °C for 30 minutes, at 250 °C for 30 minutes, and at 300 °C for 60 minutes to form a polyimide film.

The film was tested for the radioactive impurities and the properties as in Example 1 and the results are shown in Tables 1 and 2.

A silicon wafer was spin-coated with the precursor solution, dried at 140 °C for 30 minutes, spin-coated with a positive photoresist (AZ-1350J, product of Shipley Far East Ltd.), dried, selectively exposed through

a photomask with a test pattern for the formation of through-holes ranging from 1 µm square to 10 µm square, treated with a developer (MF-312, product of Shipley Far East Ltd.) for simultaneous development of the photoresist and etching of the unprotected portion of the polyimide precursor film, and stripped of the photoresist with acetone. A good through-hole pattern down to 4 µm was observed on the polyimide precursor film.

Examples 7 - 10

Polyimide precursor solutions were prepared as in Example 1 using the formulations shown in Table 1 and converted to polyimide films. The films were tested for the radioactive impurities and the properties and the results are shown in Tables 1 and 2.

The patterning test with the photoresist produced a good 4 µm through-hole pattern.

Table 1

| | | Example | | | | | | | | | | Comparative Example | |
|---|---|---|---|---|---|---|---|---|---|---|---|---|---|
| | | 1 | 2 | 3 | 4 | 5 | 6 | 7 | 8 | 9 | 10 | 1 | 2 |
| Raw materials for polymerization and amounts used (mol%) | | Tetracarboxylic acid dianhydrides | | | | | | | | | | | |
| | | PMDA:15 | PMDA:25 | PMDA:10 | PMDA:15 | PMDA:25 | PMDA:10 | PMDA:25 | PMDA:10 | PMDA:25 | PMDA:25 | BTDA:50 | DSDA:50 |
| | | DSDA:35 | BTDA:25 | BTDA:40 | BTDA:35 | BPDA:25 | DSDA:40 | BTDA:25 | BTDA:40 | BTDA:25 | BPDA:25 | — | — |
| | | Aromatic diamines | | | | | | | | | | | |
| | | TPE-R 25 | TPE-R 32.5 | TPE-R 25 | TPE-R 20 | TPE-Q 15 | BIS-AP 25 | BIS-AM 25 | BIS-AM 25 | BIS-AM 20 | BIS-AP 15 | — | — |
| | | DAE 22.5 | DAE 15 | 3,3'-DDS 22.5 | BIS-A-AF 27.5 | BAA-34 30 | DAE 22.5 | DAE 22.5 | 3,3'-DDS 22.5 | BIS-A-AF 27.5 | BAA-34 30 | DAE 47.5 | DAE 47.5 |
| | | Diaminosiloxanes | | | | | | | | | | | |
| | | GAPD 2.5 | GAPD 2.5 | PSX 2.5 | GAPD 2.5 | GAPD 5 | GAPD 2.5 | GAPD 2.5 | PSX 2.5 | GAPD 2.5 | GAPD 5 | PSX-740 2.5 | GAPD 2.5 |
| Solution viscosity (cp) | | 2500 | 1800 | 2200 | 2700 | 1800 | 4500 | 5000 | 5400 | 6500 | 6200 | 4800 | 3200 |
| Reaction solvent | | NMP+Dig | NMP+Dig | NMP+Dig | NMP+Dig | NMP+Dig | NMP+Dig | NMP+Dig | NMP+Dig | NMP+BCA | NMP+BCA | NMP+Dig | NMP+Dig |
| Radioactive impurities (ppb) | U | 0.02 | 0.01 | 0.02 | 0.02 | 0.02 | 0.01 | 0.01 | 0.02 | 0.01 | 0.01 | 0.03 | 0.02 |
| | Th | 0.01 | 0.01 | 0.01 | 0.01 | 0.01 | 0.01 | 0.01 | 0.01 | 0.01 | 0.01 | 0.01 | 0.01 |
| Adhesion to wafer | | 100/100 | 100/100 | 100/100 | 100/100 | 100/100 | 100/100 | 100/100 | 100/100 | 100/100 | 100/100 | 100/100 | 100/100 |

(Notes) Adhesion to wafer: residual area in cross-cut tape test

Table 2

| | Example | | | | | | | | | | Comparative Example | |
|---|---|---|---|---|---|---|---|---|---|---|---|---|
| | 1 | 2 | 3 | 4 | 5 | 6 | 7 | 8 | 9 | 10 | 1 | 2 |
| Tensile modulus *1) | 245 | 260 | 225 | 250 | 265 | 220 | 242 | 215 | 237 | 275 | – | – |
| Tensile strength *2) | 12.3 | 14.2 | 10.7 | 11.3 | 14.5 | 12.1 | 13.3 | 11.3 | 11.8 | 14.0 | – | – |
| Elongation *3) | 14.2 | 12.3 | 18.9 | 12.2 | 10.7 | 10.2 | 12.1 | 13.7 | 12.7 | 11.1 | – | – |
| Initial thermal decomposition temperature *4) | 502 | 515 | 495 | 511 | 490 | 470 | 505 | 503 | 501 | 515 | – | – |
| Glass transition temperature *5) | 290 | 303 | 270 | 273 | 310 | 250 | 275 | 247 | 263 | 285 | – | – |
| Thermal expansion coefficient *6) | 32.6 | 30.5 | 34.5 | 42.3 | 27.5 | 45 | 37 | 42 | 35 | 33 | – | – |
| Dielectric constant *7) | 3.3 | 3.4 | 3.4 | 3.4 | 3.3 | 3.1 | 3.1 | 3.0 | 3.1 | 3.2 | – | – |
| Dielectric loss *8) | 8.5 | 8.4 | 8.4 | 8.4 | 8.6 | 9.2 | 8.6 | 8.9 | 8.6 | 8.1 | – | – |
| Moisture absorption (%) *9) | 0.9 | 0.8 | 0.9 | 0.6 | 0.6 | 0.8 | 0.7 | 0.6 | 0.4 | 0.4 | 1.3 | 1.3 |

(Notes) *1) $kg/mm^2$
*2) $kg/mm^2$
*3) %
*4) °C, determined by TGA (thermogravimetric analysis) in nitrogen stream at test speed of 10 °C/min.
*5) Dynamic thermoelasticity determined in nitrogen stream at test speed of 5 °C/min.
*6) $\times 10^{-6}$/ °C, determined by TMA (thermomechanical analysis) in nitrogen stream at test speed of 10°C/min.
*7) Determined at 20 °C, 60% relative humidity, and 1 MHz
*8) $\times 10^{-3}$, determined at 20 °C, 60% relative humidity, and 1 MHz
*9) Increase in weight after storage at 78% relative humidity for 24 hours

## Industrial Applicability

This invention is capable of producing resins for protection of semiconductors which show good adhesion to silicon-containing substrates such as silicon wafers and are readily patternable with through-hole formation by a wet etching process using photoresists.

**Claims**

1. Resins for protection of semiconductors comprising polyimides having (a) 20 to 80 mol% of the repeating unit of the following general formula (1), (b) 10 to 89 mol% of the repeating unit of the following general formula (2), and (c) 1 to 70 mol% of the repeating unit of the following general formula (3)

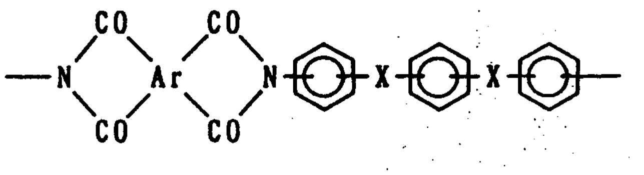

(1)

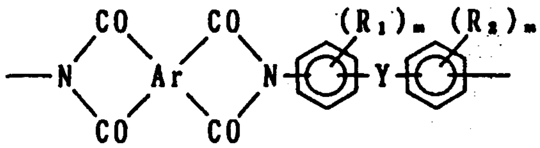

(2)

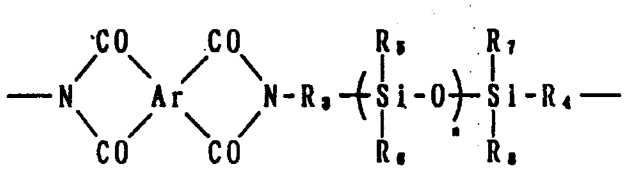

(3)

wherein Ar is at least one radical selected from

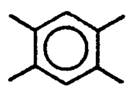

and radicals of the general formula

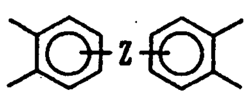

in which Z is a direct bond, -CO-, and $-SO_2-$, X is -O- or $-C(CH_3)_2-$, Y is a direct bond or at least one radical selected from -O-, $-SO_2-$, $-C(CH_3)_2-$, and $-C(CF_3)_2-$, $R_1$ and $R_2$ are alkyl groups, m is an integer from 0 to 4, $R_3$ and $R_4$ are divalent organic radicals, $R_5$ to $R_8$ are hydrocarbon radicals having 1 to 6 carbon atoms, and n is an integer from 1 to 5.

2. Resins for protection of semiconductors according to claim 1 wherein Ar contains 20 to 80 mol% of the following formula.

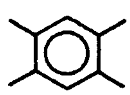

3. Resins for protection of semiconductors according to claim 1 wherein said polyimides contain 1 to 30

mol% of the repeating unit of the general formula (3).

**4.** Semiconductor devices which are provided with through-holed protective resin films and encapsulated with encapsulating materials, said protective resin films comprising polyimides having (a) 20 to 80 mol% of the repeating unit of the following general formula (1), (b) 10 to 89 mol% of the repeating unit of the following general formula (2), and (c) 1 to 70 mol% of the repeating unit of the following general formula (3)

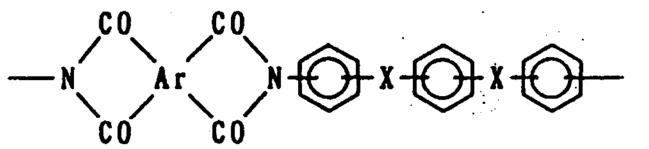
(1)

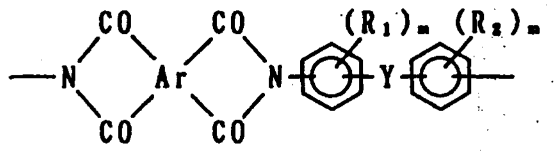
(2)

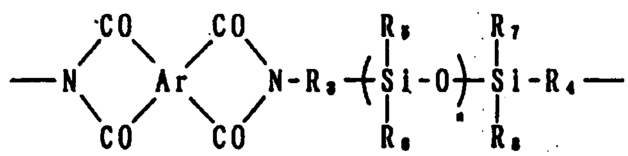
(3)

wherein Ar is at least one radical selected from

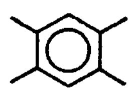

and radicals of the general formula

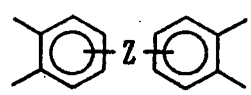

in which Z is a direct bond, -CO-, or $-SO_2-$, X is -O- or $-C(CH_3)_2-$, Y is a direct bond or at least one radical selected from -O-, $-SO_2-$, $-C(CH_3)_2-$, and $-C(CF_3)_2-$, $R_1$ and $R_2$ are alkyl groups, m is an integer from 0 to 4. $R_3$ and $R_4$ are divalent organic radicals, $R_5$ to $R_8$ are hydrocarbon radicals having 1 to 6 carbon atoms, and n is an integer from 1 to 5.

# INTERNATIONAL SEARCH REPORT

International Application No PCT/JP91/00044

**I. CLASSIFICATION OF SUBJECT MATTER** (if several classification symbols apply, indicate all) [6]

According to International Patent Classification (IPC) or to both National Classification and IPC

Int. $Cl^5$ C08G73/10, H01L23/29

**II. FIELDS SEARCHED**

Minimum Documentation Searched [7]

| Classification System | Classification Symbols |
|---|---|
| IPC | C08G73/10, H01L23/29 |

Documentation Searched other than Minimum Documentation to the Extent that such Documents are Included in the Fields Searched [8]

| | |
|---|---|
| Jitsuyo Shinan Koho | 1926 - 1991 |
| Kokai Jitsuyo Shinan Koho | 1971 - 1991 |

**III. DOCUMENTS CONSIDERED TO BE RELEVANT** [9]

| Category * | Citation of Document, [11] with indication, where appropriate, of the relevant passages [12] | Relevant to Claim No. [13] |
|---|---|---|
| X | JP, A, 63-13032 (Ube Industries, Ltd.), January 20, 1988 (20. 01. 88), Line 5, left column to line 4, right column, page 1, line 11, lower left column, page 2 to 5th line from the bottom, lower left column, page 3 (Family: none) | 1-4 |
| X | JP, A, 64-23252 (Ube Industries, Ltd.), January 25, 1989 (25. 01. 89), Line 4, left column, page 1 to line 5, upper left column, page 2, line 9, upper right column, page 3 to 4th line from the bottom, upper right column, page 4, lines 4 to 17, left column, page 9 (Family: none) | 1-4 |
| X | JP, A, 63-172735 (Chisso Corp.), July 16, 1988 (16. 07. 88), Line 4, left column to 7th line from the bottom, right column, page 1, line 3, lower right column, page 2 to 3rd line from the bottom, lower left column, page 3 & EP, A, 276,922 & US, A, 4,923,968 | 1-4 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| April 11, 1991 (11. 04. 91) | April 22, 1991 (22. 04. 91) |
| **International Searching Authority** | **Signature of Authorized Officer** |
| Japanese Patent Office | |

**FURTHER INFORMATION CONTINUED FROM THE SECOND SHEET**

| | | |
|---|---|---|
| | right column, page 6 (Family: none) | |
| Y | JP, A, 62-223228 (Sumitomo Bakelite Co., Ltd.), October 1, 1987 (01. 10. 87), Line 4, left column to line 12, right column, page 1, line 4, upper left column, page 2 to line 4, lower left column, page 3, lines 5 to 11, upper right column, page 5 (Family: none) | 1-4 |
| Y | JP, A, 63-33626 (Sumitomo Bakelite Co., Ltd.), February 16, 1988 (16. 02. 88), | 1-4 |

**V. ☐ OBSERVATIONS WHERE CERTAIN CLAIMS WERE FOUND UNSEARCHABLE [1]**

This international search report has not been established in respect of certain claims under Article 17(2) (a) for the following reasons:

1. ☐ Claim numbers , because they relate to subject matter not required to be searched by this Authority, namely:

2. ☐ Claim numbers , because they relate to parts of the international application that do not comply with the prescribed requirements to such an extent that no meaningful international search can be carried out, specifically:

3. ☐ Claim numbers , because they are dependent claims and are not drafted in accordance with the second and third sentences of PCT Rule 6.4(a).

**VI. ☐ OBSERVATIONS WHERE UNITY OF INVENTION IS LACKING [2]**

This International Searching Authority found multiple inventions in this international application as follows:

1. ☐ As all required additional search fees were timely paid by the applicant, this international search report covers all searchable claims of the international application
2. ☐ As only some of the required additional search fees were timely paid by the applicant, this international search report covers only those claims of the international application for which fees were paid, specifically claims:
3. ☐ No required additional search fees were timely paid by the applicant. Consequently, this international search report is restricted to the invention first mentioned in the claims; it is covered by claim numbers:
4. ☐ As all searchable claims could be searched without effort justifying an additional fee, the International Searching Authority did not invite payment of any additional fee.

Remark on Protest

☐ The additional search fees were accompanied by applicant's protest

☐ No protest accompanied the payment of additional search fees.

FURTHER INFORMATION CONTINUED FROM THE SECOND SHEET

| | | |
|---|---|---|
| Y | JP, A, 61-143433 (Nitto Electric Industrial Co., Ltd.), July 1, 1986 (01. 07. 86), Line 4, left column to 2nd line from the bottom, left column, page 1, line 9, upper left column, page 2 to line 7, lower left column, page 3 (Family: none) | 1-4 |
| Y | JP, A, 62-11727 (Ube Industries, Inc.), January 20, 1987 (20. 01. 87), Line 4, left column to last line, right column, page 1, line 11, upper right column, page 2 to line 1, lower left column, page 3, line 1, left column to last line, | 1-4 |

V. ☐ OBSERVATIONS WHERE CERTAIN CLAIMS WERE FOUND UNSEARCHABLE [1]

This international search report has not been established in respect of certain claims under Article 17(2) (a) for the following reasons:

1. ☐ Claim numbers , because they relate to subject matter not required to be searched by this Authority, namely:

2. ☐ Claim numbers , because they relate to parts of the international application that do not comply with the prescribed requirements to such an extent that no meaningful international search can be carried out, specifically:

3. ☐ Claim numbers , because they are dependent claims and are not drafted in accordance with the second and third sentences of PCT Rule 6.4(a).

VI. ☐ OBSERVATIONS WHERE UNITY OF INVENTION IS LACKING [2]

This International Searching Authority found multiple inventions in this international application as follows:

1. ☐ As all required additional search fees were timely paid by the applicant, this international search report covers all searchable claims of the international application

2. ☐ As only some of the required additional search fees were timely paid by the applicant, this international search report covers only those claims of the international application for which fees were paid, specifically claims:

3. ☐ No required additional search fees were timely paid by the applicant. Consequently, this international search report is restricted to the invention first mentioned in the claims; it is covered by claim numbers:

4. ☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

**FURTHER INFORMATION CONTINUED FROM THE SECOND SHEET**

| | | |
|---|---|---|
| | Line 4, left column to line 15, ritht column, page 1, line 7, upper left column, page 2 to line 18, lower left column, lines 4 to 10, upper right column, page 5 (Family: none) | |
| Y | JP, A, 59-56453 (Nitto Electric Industrial Co., Ltd.), March 31, 1984 (31. 03. 84), Line 4, left column, page 1 to line 6, upper left column, line 9, upper left column, page 5 to last line, right column, page 7 (Family: none) | 1-4 |

**V. ☐ OBSERVATIONS WHERE CERTAIN CLAIMS WERE FOUND UNSEARCHABLE [1]**

This international search report has not been established in respect of certain claims under Article 17(2) (a) for the following reasons:

1. ☐ Claim numbers , because they relate to subject matter not required to be searched by this Authority, namely:

2. ☐ Claim numbers , because they relate to parts of the international application that do not comply with the prescribed requirements to such an extent that no meaningful international search can be carried out, specifically:

3. ☐ Claim numbers , because they are dependent claims and are not drafted in accordance with the second and third sentences of PCT Rule 6.4(a).

**VI. ☐ OBSERVATIONS WHERE UNITY OF INVENTION IS LACKING [2]**

This International Searching Authority found multiple inventions in this international application as follows:

1. ☐ As all required additional search fees were timely paid by the applicant, this international search report covers all searchable claims of the international application.
2. ☐ As only some of the required additional search fees were timely paid by the applicant, this international search report covers only those claims of the international application for which fees were paid, specifically claims:
3. ☐ No required additional search fees were timely paid by the applicant. Consequently, this international search report is restricted to the invention first mentioned in the claims; it is covered by claim numbers:
4. ☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.